Europäisches Patentamt

European Patent Office

Office européen des brevets

(19)

(11) Veröffentlichungsnummer: **0 123 874**
**B1**

(12) **EUROPÄISCHE PATENTSCHRIFT**

(45) Veröffentlichungstag der Patentschrift: **28.11.90**

(21) Anmeldenummer: **84103114.9**

(22) Anmeldetag: **21.03.84**

(51) Int. Cl.[5]: **H 03 K 17/687,** H 03 K 17/78, H 03 F 3/08, H 03 F 3/16

(54) **Vorrichtung zur Erzeugung einer Gate-Vorspannung an Feldeffekttransistoren.**

(30) Priorität: **29.03.83 DE 3311489**

(43) Veröffentlichungstag der Anmeldung:
**07.11.84 Patentblatt 84/45**

(45) Bekanntmachung des Hinweises auf die Patenterteilung:
**28.11.90 Patentblatt 90/48**

(84) Benannte Vertragsstaaten:
**DE FR GB IT**

(56) Entgegenhaltungen:
**DE-A-2 840 937**
**FR-A-2 329 072**
**US-A-3 611 173**
**US-A-4 121 168**

**E.D.N. ELECTRICAL DESIGN NEWS, Band 27, Nr. 20, 13. Oktober 1982, Seiten 41,42,44,46,48,50,52,54, Boston, Massachusetts, US; B. TRAVIS: "Latest-generation optoelectronic ICs gain functions, improve specs"**

(73) Patentinhaber: **Siemens Aktiengesellschaft**
**Wittelsbacherplatz 2**
**D-8000 München 2 (DE)**

(72) Erfinder: **Zimmermann, Walter, Ing.grad.**
**Oberdorfen Eichenweg 9**
**D-8250 Dorfen (DE)**

# Beschreibung

Die Erfindung betrifft eine Vorrichtung zur Erzeugung einer Gate-Vorspannung an Feldeffekttransistoren.

Beim Betreiben von Feldeffekttransistoren ist außer einer Betriebsspannung, die zwischen Source und Drain angelegt ist eine weitere Spannung zwischen Gate und Substrat bzw. zwischen Gate und Kanal oder zwischen Gate und Source oder Drain erforderlich. Beispielsweise werden Feldeffekttransistoren vom Verarmungstyp in der Regel so beschaltet, daß neben einer Betriebsspannung zwischen Source und Drain eine der Betriebsspunnung entgegengesetzte Spannung zwischen Gate und Source angelegt wird. Bei derartigen n-Kanal Feldeffekttransistoren ist somit neben einer positiven Betriebsspunnung eine negative Gate-Vorspannung erforderlich. Eine solche negative Gate-Vorpsannung kann beispielsweise über eine zusätzliche externe Spannungsquelle zugeführt werden. Externe Spannungsquellen sind abgesehen von deren Aufwand in verschiedenen Anwendungsbereichen nicht praktikabel.

Eine weitere Möglichkeit besteht mittels Spannungswandlern aus der vorgegebenen Betriebsspannung durch Umladung energiespeichernder Elemente eine negative Gate-Vorspannung zu erzeugen. Eine derartige Erzeugung der Gate-Vorspannung ist aufwendig und daher unvorteilhaft.

Weiterhin läßt sich eine negative Gate-Vorspannung durch eine Sourcepotentialanhebung gegen Masse erreichen wobei die Sourceelektrode mit einem Kondensator hochfrequenzmäßig gegen die Bezugsmasse zu blockieren ist. Die Impedanzverhältnisse für die hockfrequenzmäßige Sourceerdung werden jedoch durch einen zwischengeschalteten Kondensator erheblich gestört, weshalb eine derartige Gatevorspannungserzeugung für Feldeffekttransistoren nicht akzeptabel ist die in einem Frequenzbereich von ca. 3 bis 5 GHz, wie z.B. Galliumarsenid Feldeffekttransistoren, arbeiten.

In vielen Fällen in der Mikrowellentechnik ist eine unmittelbare Sourceerdung unumgänglich, so daß eine zweite negative Betriebsspannung zur Einstellung des Drainsstroms notwendig wird. Eine Einstellung oder Regelung des Drainstromes in Abhängigkeit von der Gate-Vorspannung ist bei Feldeffekttransistoren z.B. in Hinblick auf eine Arbeitspunkteinstellung oder -Regelung von Bedeutung.

Aus FR—A—2 329 072 ist eine Feldeffekttransistorschaltung bekannt, bei der eine Lichtquelle in Serie mit einem Feldeffekttransistor zusammengeschaltet ist, wobei die Fotoenergie der Litchquelle wenigstens in einer Fotodiode einen Strom erzeugt. Es ist jedoch nicht ersichtlich, daß eine Diode am Gate des Feldeffekttransistors den Kanalstrom in Abhängigkeit von der Fotoenergie beeinflußt.

Aufgabe der vorliegenden Erfindung ist es eine Vorrichtung zur Erzeugung einer Gate-Vorspannung an Feldeffekttransistoren anzugeben, die aus einer vorgegebenen Betriebsspannung eine weitere Spannung erzeugt, die galvanisch getrennt oder galvanisch gekoppelt außerhalb dem vorgegebenen Betriebsspannungsbereich liegt und zur Gate-Vorspannungserzeugung und/oder zur Einstellung oder Regelung des Kanalstroms für Feldeffekttransistoren dient. Diese Aufgabe wird erfindungsgemäß durch die Merkmale des Anspruchs 1 gelöst.

Vorteilhafte Ausgestaltungen der erfindungsgemäßen Vorrichtung sind in der Unteransprüchen angegeben.

Nachfolgend wird die Erfindung anhand der Zeichnung und von Ausführungsbeispielen näher erläutert.

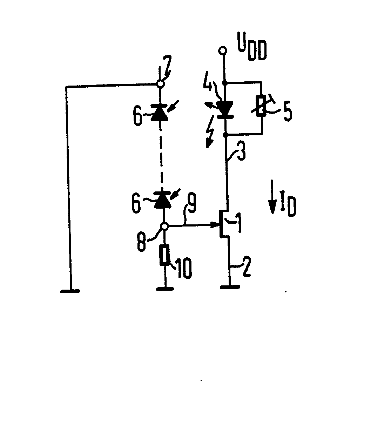

Die einzige Figur zeigt den prinzipiellen Aufbau eines Ausführungsbeispiels der erfindungsgemäßen Vorrichtung. In der Fig. 1 ist ein Feldeffekttransistor 1 dargestellt, dessen Source 2 geerdet ist und dessen Drain 3 an den Eingang einer elektrisch betriebenen Litchquelle einer lichtmittierenden Diode 4, LED, angeschlossen ist, während der Ausgang der LED 4 an der Betriebsspannung des Feldeffekttransistors, der Drain-Spannung $U_{DD}$ anliegt. Parallelgeschaltet zur LED 4 befindet sich ein Potentiometer 5 zur Einstellung des Arbeitspunktes des Kanalstromes $I_D$. Wird der Feldeffekttransistor (1) von einem Drainstrom $I_D$ durchfolssen, so fließt auch zumindest ein Teil dieses Stromes durch die LED 4. Bei ausreichendem Stromfluß durch die LED 4 strahlt diese Licht ab, welches bei geeigneter Anordnung von ein oder mehreren, insbesondere von sechs Fotoelementen 6 empfangen und in eine Fotospannung umgesetzt wird. Anstelle einer LED können auch mehrere parallel oder hintereinander geschaltete LED's oder auch andere entsprechend geschaltete elektrische Lichtquellen verwendet werden. Sind mehrere Fotoelemente 6 vorhanden so sind diese hintereinander geschaltet. An einem freien Kontakt 7 der hintereinander geschalteten Fotoelemente 6 wird ein höheres Potential erzeugt, während am anderen freien Kontakt 8 der hintereinander geschalteten Fotoelemente 6 ein niedrigeres Potential erzeugt wird. Zur Regelung des Drainstromes eines mit negativer Gate-Vorspannung betriebenen Feldeffekttransistors wird der Kontakt 7 geerdet und der Kontakt 8 einerseits an das Gate 9 des Feldeffekttransistors und andererseits an das eine Ende eines ohmschen Widerstandes 10 gelegt, dessen anderes Ende geerdet ist. Da die negative Gatevorspannung dem Drainstrom durch den sie entstanden ist entgegen wirkt, wird mit dieser Schaltung eine Drain-Stromregelung bewirkt. Ein Anschwellen des Drainstromes hat zur Folge, daß die von der LED abgegebene Strahlungsenergie größer wird. Diese größere Strahlungsenergie erzeugt wiederum an den Fotoelementen eine größere Fotospannung, was eine stärker negative Gate-Vorspannung bewirkt, die den im Transistor 1 fließenden Drainstrom in einem stärkeren Maße drosselt. Mit einer Vorrichtung wie sie in der Zeichnung dargestellt ist wird eine Gate-Vorspannung aus einer einzigen vorgegebenen Betriebsspannung erzeugt, und es wird gleichzeitig eine echte Regelung des Drainstromes erreicht.

Die erfindungsgemäße Vorrichtung kann vorteilhaft zur Erzeugung einer Gate-Vorspannung bei Galliumarsenid-Feldeffekttransistoren verwendet werden. In der Regel werden dazu zur Gate-Vorspannungseinstellung Ströme benötigt die kleiner als 10 µA, insbesondere kleiner als 1 µA sind. Weiterhin kann die erfindungsgemäße Vorrichtung für die galvanisch getrennte Signalsteuerung bei Leistungs-MOS Transistoren benutzt werden.

Bei verschiedenen Anwendungen können LED und Fotoelemente in Form von Optokopplern zusammengefügt sein. Für die Signalsteuerung von Leistungs-MOS-Transitoren werden dabei bis zu 6 Fotoelemente verwendet, da die benötigte Gate-Vorspannung −1V bis −2,5V beträgt.

Prinzipiell kann die erfindungsgemäße vorrichtung zur Gate-Vorspannungserzeugung bei allen Feldeffekttransistoren verwendet werden, die bei anliegender Drain-Spannung einen Drain-Strom aufweisen, gleichgültig ob dieser Drain-Strom bei einer Gate-Spannung von 0 V stets im Feldeffekttransistor fließt oder ab dieser Drain-Strom durch eine geeignete Vorschaltelektronik in einem sonst stromlosen Feldeffekttransistor eigens erzeugt wird. Mit der erfindungsgemäßen Vorrichtung sind prinzipiell sowohl negative als auch positive Gate-Vorspannungen erzeugbar. Der Fall einer negativen Gate-Vorspannungserzeugung ist bei der Figurenbeschreibung behandelt. Im Falle einer positiven Gate-Vorspannungserzeugung sind die freien Kontakte 7 und 8 der hintereinander geschalteten Fotoelemente 6 zu vertauschen.

Die erfindungsgemäße Vorrichtung eignet sich insbesondere für die Anwendung in der Mikrowellentechnik.

## Patentansprüche

1. Vorrichtung zur Einstellung eines Kanal-Stroms bei einer Feldeffekttransistorschaltung im Hinblick auf eine Arbeitspunkteinstellung, wobei eine elektrische Vorrichtung (5) zur Einstellung des kanalstroms parallel zu einer elektrisch betriebenen Lichtquelle (4) geschaltet ist, und wobei diese Parallelschaltung in Serie so mit einem Feldeffekttransistor (1) zusammengeschaltet ist, daß mindestens ein Teil des Kanal-Stroms die Lichtquelle (4) betreibt, welche Fotoenergie abstrahlt, wobei die Fotoenergie an wenigstens einem Fotoelement (6) eine Gleichspannung erzeugt, die dem Gate des Feldeffekttransistors (1) unmittelbar oder mittelbar so zugeführt wird, daß die dadurch zugeführte Gate-Vorspannung dem Kanal-Strom entgegenwirkt.

2. Vorrichtung nach Anspruch 1, dadurch gekennzeichnet, daß die elektrische Vorrichtung zur Einstellung des Kanalstromes aus einem Potentiometer (5) besteht.

3. Vorrichtung nach Anspruch 1 und/oder 2, dadurch gekennzeichnet, daß als Lichtquellen (4) lichtimitierende Dioden (LED's) angebracht sind.

4. Vorrichtung nach mindestens einem der Ansprüche 1 bis 3, dadurch gekennzeichnet, daß bis zu sechs hintereinander geschaltete Fotoelemente (6) angebracht sind.

5. Vorrichtung nach Anspruch 3 und 4, dadurch gekennzeichnet, daß die lichtimitierenden Dioden (4) und Fotoelemente (6) in Form von Optokopplern zusammengefügt sind.

6. Vorrichtung nach mindestens einem der Ansprüche 1 bis 5, dadurch gekennzeichnet, daß als Feldeffekttransistoren Galliumarsenidfeldeffekttransistoren zur Anwendung kommen.

## Revendications

1. Dispositif pour ajuster un courant de canal dans un circuit à transistors à effet de champ en vue de régler un point de fonctionnement, du type dans lequel un dispositif électrique (5) servant à regler le courant de canal est monté en parallele sur un source lumineuse (4) fonctionnant par voie électrique, et dans lequel ce montage parallèle est branché en série avec un transistor à effet de champ (1) de manière qu'au moins un partie du courant de canal alimente la source lumineuse (4) qui émet une énergie photoélectrique, alors que cette dernière produit au niveau d'au moins un élément photoélectrique (6) une tension continue qui est appliquée directement ou indirectement de telle façon à la grille du transistor à effet de champ (1) que la tension de polarisation de grille ainsi appliquée agit à l'encontre du courant de canal.

2. Dispositif selon la revendication 1, caractérisé par le fait que le dispositif électrique qui sert à régler le courant de canal est constitué par un potentiomètre (5).

3. Dispositif selon la revendication 1 et/ou 2, caractérisé par le fait que l'on met en oeuvre, comme sources lumineuses (4), des diodes électroluminescentes (LED).

4. Dispositif selon au moins l'une des revendications 1 à 3, caractérisé par la mise en oeuvre jusqu'à six éléments photoélectriques (6) branchés en série.

5. Dispositif selon la revendication 3 et 4, caractérisé par le fait que les diodes électroluminescentes (4) et les éléments photoélectriques (6) sont assemblés sous la forme d'optocoupleurs.

6. Dispositif selon au moins l'une des revendications 1 à 5, caractérisé par le fait que l'on met en oeuvre, comme transistors à effet de champ, des transistors à effect de champ à l'arséniure de gallium.

## Claims

1. Device for adjusting a channel current in a field-effect transistor circuit with respect to an operating point adjustment, an electrical device (5) for adjusting the channel current being connected in parallel with an electrically-operated light source (4), and this parallel circuit being interconnected in series with a field-effect transistor (1) in such a way that at least a part of the channel current operates the light source (4) which radiates light energy, the light energy generating at at least one photovoltaic cell (6) a DC voltage which is fed directly or indirectly to the gate of the field-effect transistor (1) in such a way that the gate bias thus fed counteracts the channel current.

2. Device according to Claim 1, characterized in that the electrical device for adjusting the channel current comprises a potentiometer (5).

3. Device according to Claim 1 and/or 2, characterized in that light-emitting diodes (LEDs) are used as light sources (4).

4. Device according to at least one of Claims 1 to 3, characterized in that up to six series-connected photovoltaic cells (6) are employed.

5. Device according to Claims 3 and 4, characterized in that the light-emitting diodes (4) and photovoltaic cells (6) are combined in the form of optocouplers.

6. Device according to at least one of Claims 1 to 5, characterized in that gallium arsenide field-effect transistors are employed as field-effect transistors.